(19) Europäisches Patentamt
European Patent Office
Office européen des brevets

(11) **EP 4 650 799 A1**

(12) **EUROPEAN PATENT APPLICATION**

(43) Date of publication:
**19.11.2025 Bulletin 2025/47**

(21) Application number: **25170928.3**

(22) Date of filing: **16.04.2025**

(51) International Patent Classification (IPC):
**G01R 31/367** (2019.01)   **G01R 31/3828** (2019.01)
**G01R 31/3842** (2019.01)   **G01R 31/388** (2019.01)
**G01R 31/392** (2019.01)

(52) Cooperative Patent Classification (CPC):
**G01R 31/392; G01R 31/367; G01R 31/3828;
G01R 31/3842; G01R 31/388**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **01.05.2024 JP 2024074327**

(71) Applicant: **Prime Planet Energy & Solutions, Inc.
Chuo-ku, Tokyo 103-0022 (JP)**

(72) Inventor: **TANAKA, Yasuharu
Tokyo, 103-0022 (JP)**

(74) Representative: **Kuhnen & Wacker
Patent- und Rechtsanwaltsbüro PartG mbB
Prinz-Ludwig-Straße 40A
85354 Freising (DE)**

(54) **BATTERY FULL CHARGE CAPACITY ESTIMATION METHOD, BATTERY FULL CHARGE CAPACITY ESTIMATION DEVICE, AND FULL CHARGE CAPACITY ESTIMATION PROGRAM**

(57) In a step of estimating a full charge capacity of a battery 1, SOC1 and SOC2 are acquired based on voltages V1 and V2 when the battery 1 is stable. A change amount ΔSOC is acquired from SOC1 and SOC2. A current integrated value ΣA1 until SOC changes from SOC1 to SOC2 is acquired. When |ΔSOC| is equal to or more than a first threshold, the estimation portion 46 calculates an estimated value Hx from ΣA1 and ΔSOC. When a preset condition is satisfied, the estimation portion 46 makes the first threshold be a second threshold. The second threshold is a lower threshold than the first threshold.

FIG.5

# EP 4 650 799 A1

## Description

The present disclosure relates to a battery full charge capacity estimation method, a battery full charge capacity estimation device, and a full charge capacity estimation program.

## BACKGROUND

Japanese Laid-open Patent Publication No. 2002-243813 discloses a battery capacity deterioration calculation device including a charged state calculation portion that calculates a change of a charged state in a secondary battery and a battery capacity calculation portion that calculates a deterioration-time capacity battery capacity of the secondary battery. The deterioration-time capacity battery capacity is calculated based on a discharge current integrated value during discharging and a change in a charged state. The change of the charged state is calculated based on a correlation between an open voltage and the charged state and the open voltage during discharging. In this case, the correlation between the open voltage and the charged state does not depend on a deteriorated state of the secondary battery. Therefore, when the correlation is known, the change of the charged state of the secondary battery can be obtained, for example, even without a table of deterioration of an internal resistance of the secondary battery prepared, and thus, the deterioration-time battery capacity can be calculated.

Japanese Laid-open Patent Publication No. 2002-243813 describes that, in order to increase accuracy of calculation of the deterioration-time battery capacity, it is desirable to execute calculation of the deterioration-time battery capacity when the change of the charged state is relatively large.

The present inventor desires to estimate a battery full charge capacity with relatively high accuracy regardless of a degree of a change of a charged state.

## SUMMARY

A battery full charge capacity estimation method disclosed herein is a full charge capacity estimation method for estimating a capacity deterioration of a battery managed by a battery management system (BMS) mounted on an electric vehicle, and includes steps of acquiring SOC1 that is SOC acquired based on a voltage V1 that is OCV of the battery, acquiring SOC2 that is SOC acquired based on a voltage V2 that is OCV of the battery at a time after the SOC of the battery is SOC1, acquiring a change amount $\Delta$SOC between the SOC1 and the SOC2, acquiring a current integrated value $\Sigma$A1 of the battery until the SOC changes from the SOC1 to the SOC2, and acquiring, when $|\Delta SOC|$ is equal to or more than a preset first threshold, an estimated value Hx of a full charge capacity of the battery, based on Expression 1 as follows:

Expression 1: $Hx = (\Sigma A1/\Delta SOC) \times 100$.

In the battery full charge capacity estimation method, in the step of acquiring the estimated value Hx of the full charge capacity, when a preset condition is satisfied, the first threshold is made to be a second threshold that is a lower threshold than the first threshold.

According to the battery full charge capacity estimation method, a battery full charge capacity can be estimated with relatively high accuracy regardless of a degree of a change of a charged state.

## BRIEF DESCRIPTION OF THE DRAWINGS

FIG. 1 is a schematic view illustrating a battery system 100.
FIG. 2 is a graph representing an example of a change of SOC in an electric vehicle on which the battery system 100 is mounted.
FIG. 3 is a flowchart for estimating a full charge capacity of a battery 1 according to a first preferred embodiment.
FIG. 4 is a graph representing a relationship between an open circuit voltage OCV and SOC.
FIG. 5 is a graph representing a relationship between a number of times it has been determined that $|\Delta SOC|$ is lower than a threshold Tx and the threshold Tx.
FIG. 6 is a flowchart for estimating a full charge capacity of the battery 1 according to a second preferred embodiment.
FIG. 7 is a flowchart for estimating a full charge capacity of the battery 1 according to a third preferred embodiment.
FIG. 8 is a flowchart for estimating a full charge capacity of the battery 1 according to a fourth preferred embodiment.
FIG. 9 is a graph representing a capacity deterioration model DM of the battery 1.

DETAILED DESCRIPTION

Preferred embodiments of a technology disclosed herein will be described below with reference to the accompanying drawings. As a matter of course, the preferred embodiments described herein are not intended to be particularly limiting the present disclosure.

The accompanying drawings are schematic and do not necessarily reflect actual members or portions. Members/portions that have the same effect will be denoted by the same sign as appropriate, and the overlapping description will be omitted as appropriate.

<First Preferred Embodiment>

<Battery System 100>

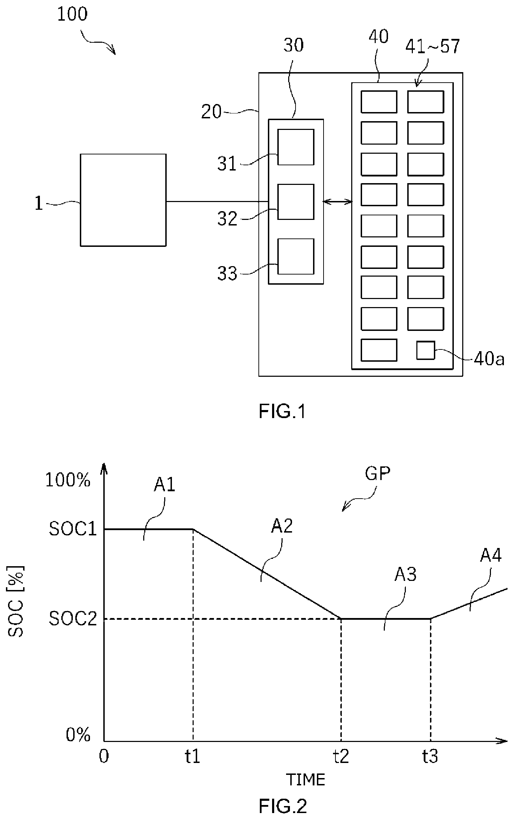

FIG. 1 is a schematic view illustrating a battery system 100. As illustrated in FIG. 1, the battery system 100 includes a battery 1 and a control unit 20. The battery 1 is connected to an unillustrated external load. The control unit 20 manages charging and discharging of the battery 1. That is, the control unit 20 is an example of a battery management system (BMS) in the present disclosure. The battery system 100 is, for example, an on-vehicle system for a battery electric vehicle (battery EV).

In this specification, the term "battery" refers to electricity storage devices from which electric energy can be taken out. The term "battery" encompasses secondary batteries that can be repeatedly charged and discharged by moving of a charge carrier between a pair of electrodes (a positive electrode and a negative electrode) via an electrolyte and, for example, encompasses lithium-ion secondary batteries. There is no particular limitation on a use form of a battery. The term "battery" encompasses assembled batteries which include multiple secondary batteries (battery cells) electrically connected mutually. In this preferred embodiment, a battery is, for example, a so-called on-vehicle battery that serves as a power source of an electric vehicle. When a battery is used as an on-vehicle battery, the battery is connected to a charge and discharge device, as appropriate, and is charged.

A full charge capacity of the battery 1 reduces over time as the battery 1 is charged and discharged. The full charge capacity is a battery capacity until the battery 1 that has been charged such that a state of charge (SOC) that is a maximum charge capacity is 100% is completely discharged.

The control unit 20 includes a sensor 30 and a control device 40. The sensor 30 includes a voltage sensor 31, a temperature sensor 32, and a current sensor 33. The control device 40 includes a storage portion 41, a first charged state acquisition portion 42, a second charged state acquisition portion 43, a change amount acquisition portion 44, a current integrated value acquisition portion 45, an estimation portion 46, a determination portion 47, a counting portion 48, a frequency determination portion 49, an unexecuted time measurement portion 50, an unexecuted time acquisition portion 51, a time determination portion 52, a travel distance measurement portion 53, a travel distance acquisition portion 54, a distance determination portion 55, an estimated capacity acquisition portion 56, and an estimated value determination portion 57. For example, the control device 40 can be a computer, such as an electronic control unit (ECU), a microcomputer mounted circuit board, or the like. The computer performs, for example, a desired function in accordance with a preset program. Each function of the computer is processed by cooperation of an arithmetic device (which will be also referred to as a processor, a central processing unit (CPU)), or a micro-processing unit (MPU), a storage device (memory, hard disk, or the like) of a computer, and a software. In this preferred embodiment, the control device 40 is realized by an ECU. A full charge capacity estimation program 40a is installed in the control device 40. The full charge capacity estimation program 40a is a program configured to realize each of the portions 41 to 57 of the control device 40. The control device 40 is configured to be communicable with the sensor 30.

Although not illustrated, the control device 40 may be realized by cooperation of multiple control devices. For example, when the control device 40 is connected to an external computer via a LAN cable, the Internet, or the like such that data communication between the control device 40 and the external computer is enabled, processing of the control device 40 may be performed by cooperation with the external computer as described above. For example, information stored in the control device 40 or a part of the information may be stored in the external computer, and processing that is executed by the control device 40 or a part of the processing may be executed by the external computer.

FIG. 2 is a graph GP illustrating an example of a change of SOC in an electric vehicle on which the battery system 100 is mounted. An abscissa of the graph GP represents a time, and an ordinate of the graph GP represents SOC of the battery 1. In the graph GP, an area sectioned by a time 0 to a time t1 is an area A1. Similarly, in the graph GP, an area sectioned by a time t1 to a time t2, an area sectioned by a time t2 to a time t3, and an area at and after a time t3 are areas A2, A3, and A4, respectively. The area A1 is an area in which an ignition of the electric vehicle on which the battery system 100 is mounted (which will be hereinafter simply referred to as "ignition") is off and SOC is SOC1. The area A2 is an area in which the ignition is on after the area A1. For example, during a time corresponding to the area A2, the electric vehicle travels. When the electric vehicle travels, the battery 1 (see FIG. 1) is discharged, and SOC decreases. However, the battery 1 may be a battery in which, when the electric vehicle travels, SOC increases. For example, in a HEV on which an engine is mounted, SOC after traveling is larger than SOC before traveling in some cases. The area A3 is an area in which the ignition is off and SOC is SOC2. SOC2 indicates a state where the battery 1 has been discharged more than SOC1. The area A4 is an area in which the ignition is on during a time following the area A3.

The voltage sensor 31 of the sensor 30 illustrated in FIG. 1 is a sensor that detects a voltage value of the battery 1. For example, the voltage sensor 31 detects the detected voltage value of the battery 1 as an analog signal. The detected analog signal is converted to a digital signal by an A/D converter (not illustrated) and is output to the storage portion 41 of the control device 40. Similar to the voltage sensor 31, the temperature sensor 32 and the current sensor 33 of the sensor 30 detect a temperature of the battery 1 and a current value of the battery 1, respectively. The temperature and the current value that have been detected are transmitted to the storage portion 41. Therefore, the voltage value, a temperature value, and the current value are stored in the storage portion 41 of the control device 40. The sensor 30 detects each value in each of a state where the ignition is on and a state where the ignition is off. Each of the voltage sensor 31, the temperature sensor 32, and the current sensor 33 detects a corresponding one of the voltage value, the temperature value, and the current value at a preset interval. Although there is no particular limitation on the interval at which each of the voltage sensor 31, the temperature sensor 32, and the current sensor 33 executes detection, the interval is, for example, about 0.001 to 1 seconds.

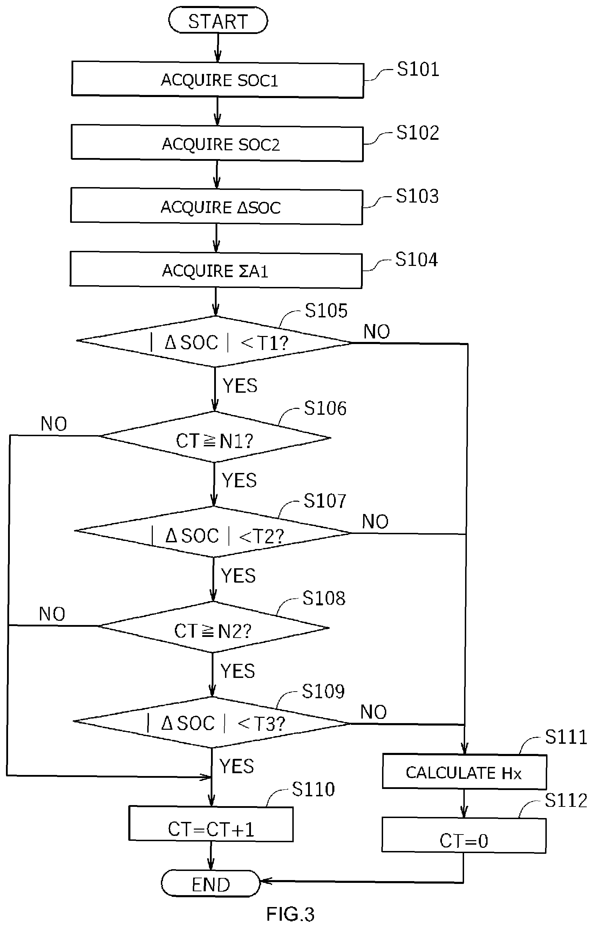

A method for estimating the full charge capacity of the battery 1 by the control unit 20 will be described below along with a configuration of the control unit 20. FIG. 3 is a flowchart for estimating the full charge capacity of the battery 1 according to a first preferred embodiment. A flow illustrated in FIG. 3 is performed at the time t3 (when the ignition is turned on at a boundary between the area A3 and the area A4) illustrated in FIG. 2. However, a timing at which the flow starts is not limited thereto.

Step S101 illustrated in FIG. 3 is a step of acquiring SOC1 that is SOC acquired based on a voltage V1 that is an open circuit voltage (OCV) of the battery 1. Step S101 can be realized by the first charged state acquisition portion 42 of the control device 40 (see FIG. 1). Note that the voltage V1 is preferably OCV in a state where the battery 1 is stable. As used herein, the term "the battery 1 is stable" refers to a state where charging and discharging of the battery 1 is not executed and OCV does not change. In this preferred embodiment, for example, the term "the battery 1 is stable" refers to a state where the ignition is off. However, the term "OCV of the battery 1 does not change" not only refers to a state where a value of OCV does not change at all but also can encompass a temperature change, an internal reaction of the battery 1, a weak fluctuation of OCV due to a measurement error of the sensor 30, or the like. In Step S101, OCV at the time t1 (see FIG. 2) is acquired as the voltage V1. In this preferred embodiment, before the time t1, the ignition is continuously off, and therefore, the voltage at the time t1 can be considered as OCV. The first charged state acquisition portion 42 first acquires the voltage value, the temperature value, and the current value detected by the voltage sensor 31, the temperature sensor 32, and the current sensor 33, respectively, from the storage portion 41. The first charged state acquisition portion 42 acquires each data at the time t1. Note that, when the voltage value detected by the voltage sensor 31 is a close circuit voltage, OCV may be estimated using the close circuit voltage, a known voltage behavior model, or the like.

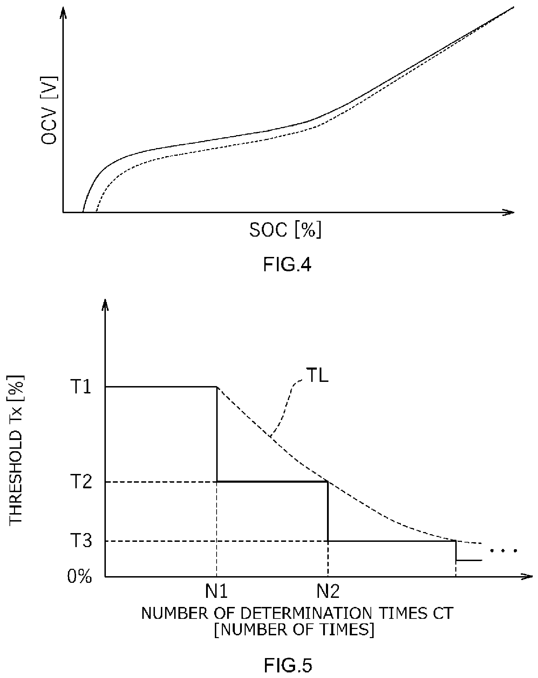

SOC1 of the battery 1 is estimated based on the estimated voltage V1. In this preferred embodiment, SOC1 of the battery 1 is estimated using an OCV-SOC conversion table (see FIG. 4) stored in the control device 40 in advance. The OCV-SOC conversion table may be acquired in advance by test, simulation, theoretical calculation, or the like and be stored in the control device 40.

FIG. 4 is a graph representing a relationship between the open circuit voltage OCV and SOC. In FIG. 4, the relationship between the open circuit voltage OCV and SOC is represented by a graph. Note that, in FIG. 4, the relationship between the open circuit voltage OCV and SOC is schematically indicated, and does not necessarily reflect an actual relationship. In FIG. 4, the open circuit voltage OCV after charging is indicated by a solid line, and the open circuit voltage OCV after discharging is indicated by a broken line. As illustrated in FIG. 4, in the OCV-SOC conversion table, the open circuit voltage OCV is recorded in association with SOC. In the OCV-SOC conversion table illustrated in FIG. 4, a relationship between the open circuit voltage OCV after charging and SOC and a relationship between the open circuit voltage OCV after discharging and SOC are different from each other. Depending on whether the acquired current value is a current value acquired during charging or a current value acquired during discharging, the relationship between the open circuit voltage OCV and SOC that is used for estimation of SOC may be selected as appropriate. Note that estimation of SOC of the battery 1 is not limited thereto and a known method, such as an IV method for obtaining the open circuit voltage from plots of the current value and CCV or the like, may be used therefor. A method for estimating SOC may be determined in accordance with a use form of the battery 1 or the like. In this preferred embodiment, the value of SOC1 estimated based on the OCV-SOC conversion table and the voltage V1 is 80%. However, the value of SOC1 is not limited thereto.

Step S102 illustrated in FIG. 3 is a step of acquiring SOC2 that is SOC acquired based on a voltage V2 that is OCV of the battery 1 at a time after a time when SOC of the battery 1 is SOC1. Step S102 can be realized by the second charged state acquisition portion 43 of the control device 40 (see FIG. 1). Note that, similar to the voltage V1, the voltage V2 is preferably a voltage when the battery 1 is stable. In this preferred embodiment, in Step S102, OCV at the time t3 (see FIG. 2) is acquired as the voltage V2. Similar to the first charged state acquisition portion 42, the second charged state acquisition portion 43 acquires the voltage value, the temperature value, and the current value from the storage portion 41. The second charged state acquisition portion 43 acquires the voltage value, the temperature value, and the current value at the time t3. In this preferred embodiment, during a period from the time t2 to the time t3, a state where the ignition is off continues. Therefore, the voltage value at the time t3 can be considered as OCV. Accordingly, herein, the voltage value at the time t3 is considered as the voltage V2. Note that, when the voltage value detected by the voltage sensor 31 is the closed circuit voltage, OCV may be estimated using the closed circuit voltage, a known voltage behavior model, or the like. Similar to the first charged state acquisition portion 42, the second charged state acquisition portion 43 acquires SOC2, based on the OCV-SOC conversion table (see FIG. 4) and the voltage V2. Note that, in this preferred embodiment, a value of SOC2 is 40%. However, the value of SOC2 is not limited thereto.

Step S103 illustrated in FIG. 3 is a step of acquiring a change amount $\Delta$SOC between SOC1 and SOC2. Step S103 can be realized by the change amount acquisition portion 44 of the control device 40 (see FIG. 1). The change amount acquisition portion 44 obtains a difference between SOC1 acquired by the first charged state acquisition portion 42 and SOC2 acquired by the second charged state acquisition portion 43 and acquires the change amount $\Delta$SOC. Herein, the change amount $\Delta$SOC can be obtained as $\Delta$SOC = SOC2 - SOC1. In this preferred embodiment, as described above, the value of SOC1 is 80% and the value of SOC2 is 40%, and therefore, the value of the change amount $\Delta$SOC is -40%. Therefore, in this preferred embodiment, the change amount $\Delta$SOC < 0. However, the change amount $\Delta$SOC is not limited to $\Delta$SOC < 0. For example, in a case where charging has been performed by regenerative energy while the ignition is on, the change amount $\Delta$SOC can be $\Delta$SOC $\geq$ 0.

Step S104 is a step of acquiring a current integrated value $\Sigma$A1 of the battery 1 until SOC changes from SOC1 to SOC2. Step S104 can be realized by the current integrated value acquisition portion 45 (see FIG. 1). The current integrated value $\Sigma$A1 is a current integrated value during a period from the time t1 to the time t2. Herein, the current integrated value $\Sigma$A1 is calculated as the current integrated value integrated up to a previous calculation + $\Delta$t $\times$ the current value. $\Delta$t is a preset time interval. As described above, the current sensor 33 (see FIG. 1) detects the current value with a preset interval. Therefore, $\Delta$t is a time interval between pieces of data of two consecutive current values among pieces of data stored in the storage portion 41. The current integrated value acquisition portion 45 calculates the current integrated value $\Sigma$A1 by integrating data of the current value during the period from the time t1 to the time t2 included in the storage portion 41. Note that, in this preferred embodiment, as illustrated in FIG. 2, the value of SOC reduces during the period from the time t1 to the time t2. That is, in the area A1, the battery 1 (see FIG. 1) is discharged. Herein, the current value during discharging is represented by a negative value. Therefore, $\Sigma$A1 < 0 herein. Note that, when the battery 1 is charged and the value of SOC increases, the current integrated value $\Sigma$A1 may be $\Sigma$A1 > 0.

Step S105 is a step of determining whether an absolute value |$\Delta$SOC| of the change amount $\Delta$SOC is lower than a preset threshold Tx. In Step S105, the threshold Tx is preset to a first threshold T1. The threshold Tx is a threshold used for determining whether to acquire an estimated value Hx of the battery 1 that will be described later. The threshold Tx is preset to the first threshold T1 by the estimation portion 46 (see FIG. 1). Therefore, in Step S105, whether |$\Delta$SOC| is lower than the first threshold T1 is determined. Determination in Step S105 can be realized by the determination portion 47 of the control device 40 (see FIG. 1). In this preferred embodiment, in Step S103, a value of |$\Delta$SOC| is 40%, based on $\Delta$SOC acquired by the change amount acquisition portion 44. The determination portion 47 determines whether |$\Delta$SOC| is lower than the first threshold T1. When |$\Delta$SOC| is lower than the first threshold T1, the process proceeds to Step S106. When |$\Delta$SOC| is not lower than the first threshold T1, that is, when it is determined that |$\Delta$SOC| is equal to or more than the first threshold, the process proceeds to Step S111.

Herein, the counting portion 48 of the control device 40 (see FIG. 1) counts a number of times it has been determined that |$\Delta$SOC| is lower than the threshold Tx. The counting portion 48 includes a counter (not illustrated). The number of time CT it has been determined that |$\Delta$SOC| is lower than the threshold Tx (which will be herein referred to as a "number of determination times CT") is stored in the counter.

In Step S106, whether a state where |$\Delta$SOC| is lower than the preset first threshold T1 has appeared consecutively the preset number of times is determined. Step S106 can be realized by the frequency determination portion 49 of the control device 40 (see FIG. 1). In this preferred embodiment, the frequency determination portion 49 determines whether the number of determination times CT stored in the counting portion 48 is a first number of times N1 or more. Although details will be described later, in this preferred embodiment, when it is determined that |$\Delta$SOC| is equal to or more than the first threshold, the number of determination times CT is 0 in Step S12 that will be described later. Therefore, the number of determination times CT is the number of times the state where |$\Delta$SOC| is lower than the preset first threshold T1 has appeared consecutively. In this preferred embodiment, for example, the first number of times N1 = 30 times. However, there is no particular limitation on a value of the first number of times N1. In Step S106, when it is determined that the number of determination times CT has reached the first number of times N1, the estimation portion 46 changes the threshold Tx from the first threshold T1 to a second threshold T2. The second threshold T2 is a lower value than the first threshold T1.

FIG. 5 is a graph representing a relationship between the number of determination times CT and the threshold Tx. In this preferred embodiment, as illustrated in FIG. 5, when the number of determination times CT (abscissa) is less than the first number of times N1 (30 times), the threshold Tx is set to the first threshold T1. When the number of determination times CT is equal to or more than the first number of times N1 (30 times) and less than a second number of times N2 that will be described later, the threshold Tx is set to the second threshold T2 by the estimation portion 46 (see FIG. 1). In Step S106 illustrated in FIG. 3, when it is determined that the number of determination times CT is equal to or more than the first number of times N1, the process proceeds to Step S107. When it is determined that the number of determination times CT is less than the first number of times N1, the process proceeds to Step S110.

Step S107 is a step of determining whether |ΔSOC| is lower than the preset threshold Tx. As described above, in Step S106, the threshold Tx is set to the second threshold T2. Therefore, in Step S107, whether |ΔSOC| is lower than the preset second threshold T2 is determined. Determination in Step S107 can be realized by the determination portion 47 (see FIG. 1). In Step S107, the determination portion 47 determines whether |ΔSOC| is lower than the second threshold T2. In Step S107, when it is determined that |ΔSOC| is lower than the second threshold T2, the process proceeds to Step S108. When the value of |ΔSOC| is not lower than the second threshold T2, that is, when it is determined that the value of |ΔSOC| is equal to or more than the second threshold T2, the process proceeds to S111.

In Step S108, whether a state where ΔSOC is lower than the preset second threshold T2 has appeared consecutively a preset number of times is determined. Step S108 can be realized by the frequency determination portion 49 (see FIG. 1). In this preferred embodiment, the frequency determination portion 49 determines whether the number of determination times CT stored in the counting portion 48 is equal to or more than the second number of times N2. In this preferred embodiment, for example, the second number of times N2 = 60 times. As described above, by the time when the number of determination times CT reaches the first number of times N1, determination by the frequency determination portion 49 is executed using the threshold Tx as the first threshold T1. As described above, when it is determined in Step S105 that |ΔSOC| is equal to or more than the first threshold T1, the number of determination times CT is 0 in Step S112 that will be described later. Therefore, when the number of determination times CT reaches the second number of times N2 = 60 times, it is determined consecutively the number of times corresponding to a difference between the second number of times N2 and the first number of times N1 (60 times - 30 times = 30 times) that |ΔSOC| is lower than the second threshold T2. The frequency determination portion 49 determines whether a numerical value of the number of determination times CT is equal to or more than the second number of times N2. In Step S108, when it is determined that the number of determination times CT is equal to or more than the second number of times N2, the estimation portion 46 sets the threshold Tx to a third threshold T3. As illustrated in FIG. 5, the third threshold T3 is a lower value than the second threshold T2. After the threshold Tx is set to the third threshold T3, the process proceeds to Step S109 illustrated in FIG. 3. When it is determined that the number of determination times CT is less than the second number of times N2, the process proceeds to Step S110.

Step S109 is a step of determining whether |ΔSOC| is lower than the preset threshold Tx. As described above, in Step S108, the threshold Tx is set to the third threshold T3. Step S109 is a step of determining whether |ΔSOC| is lower than the preset third threshold T3. Step S109 can be realized by the determination portion 47. The determination portion 47 determines whether |ΔSOC| is lower than the third threshold T3. In Step S109, when it is determined that |ΔSOC| is lower than the third threshold T3, the process proceeds to Step S110. When it is determined that the value of |ΔSOC| is not lower than the third threshold T3, that is, when it is determined that the value of |ΔSOC| is equal to or more than the third threshold T3, the process proceeds to S111.

Step S110 is a step of adding the numerical value of the number of determination times CT. When it is determined in Step S106 that |ΔSOC| is lower than the first threshold T1, when it is determined in Step S108 that |ΔSOC| is lower than the second threshold T2, or when it is determined in Step S109 that |ΔSOC| is lower than the third threshold T3, the counting portion 48 adds "1" to the number of determination times CT stored in the counter and stores an obtained value. When Step S110 is executed, the flow ends.

Step S111 is a step of acquiring, when |ΔSOC| is equal to or more than the preset first threshold T1, second threshold T2, or third threshold T3, the estimated value Hx of the full charge capacity of the battery 1, based on Expression 1 as follows:

[Expression 1]

$$Hx = (\Sigma A1/\Delta SOC) \times 100.$$

Step S111 can be realized by the estimation portion 46 (see FIG. 1). When the process proceeds from Step S106 to Step S111, |ΔSOC| is equal to or more than the first threshold T1. When the process proceeds from Step S108 to Step S111, |ΔSOC| is equal to or more than the second threshold T2. When the process proceeds from Step S109 to Step S111, |ΔSOC| is equal to or more than the third threshold T3. In this case, in this preferred embodiment, since ΣA1 < 0 and ΔSOC < 0, the estimated value Hx is a positive value. Note that, for example, when the battery 1 is charged in the period from the time t1 to the time t2, ΣA1 < 0 and ΔSOC < 0, and therefore, the estimated value Hx > 0 also in this case.

Step S112 is a step of initializing the number of determination times CT. In Step S112, the counting portion 48 initializes the numerical value of the number of determination times CT stored in the counter. As used herein, the term "initializing" refers to, for example, making the number of determination times that has been counted be "0." When Step S112 is executed, the flow ends.

Incidentally, in a case where battery full charge capacity estimation is executed, when a change of the charged state is relatively small, an error of detection of a voltage value or the like is relatively large with respect to a value of the change of the charged state. At this time, accuracy of an estimated value of the battery full charge capacity that is obtained using the change of the charged state is relatively low. Therefore, by executing battery full charge capacity estimation only when the change of the charged state is relatively large, an estimation result with relatively high accuracy can be obtained. However, according to the fining of the present inventor, a change of the charged state can be continuously at a level at which full charge capacity estimation is not executed for a relatively long period. For example, a case where a time during which an electric vehicle on which the battery is mounted is driven is relatively short applied to this case. At this time, full charge capacity estimation is not executed for a relatively long period, and therefore, there is a probability that a deviation between a full charge capacity of the battery estimated last and an actual full charge capacity of the battery arises.

According to the battery full charge capacity estimation method of this preferred embodiment, in the battery system 100 managed by the control unit 20 (battery management system), the estimated value Hx of the full charge capacity of the battery 1 is calculated using the current integrated value $\Sigma$A1 and the change amount $\Delta$SOC. The current integrated value $\Sigma$A1 and the change amount $\Delta$SOC are calculated based on a numerical value detected by the sensor 30. The estimated value Hx is calculated and acquired by the estimation portion 46 when $\Delta$SOC is equal to or more than the threshold Tx. In Step S105 described above, the threshold Tx is set to the first threshold T1. When |$\Delta$SOC| is smaller than the first threshold T1, the number of determination times CT stored in the counting portion 48 increases (Step S110). When the number of determination times CT reaches the first number of times N1, the estimation portion 46 changes the threshold Tx from the first threshold T1 to the second threshold T2. The second threshold T2 is a smaller value than the first threshold T1. That is, when the number of determination times CT reaches the first number of times N1, a value of the threshold Tx is relaxed, and calculation of the estimated value Hx is easily executed, as compared to when the threshold Tx is the first threshold T1. Thus, it is suppressed that calculation of the estimated value Hx is not executed for a relatively large period. Accordingly, it is possible to suppress that a deviation between the estimated value Hx and the actual full charge capacity of the battery 1 arises. Therefore, full charge capacity estimation of the battery 1 can be executed with relatively high accuracy regardless of the magnitude of the change amount $\Delta$SOC.

In the first embodiment described above, the threshold Tx changes between the first threshold T1, the second threshold T2, and the third threshold T3, but the technology disclosed herein is not limited thereto. The threshold Tx may change between two values or four or more values. The threshold Tx may be given, for example, based on an expression of a curve with respect to the number of determination times CT. That is, as indicated by a broken line in FIG. 5, a curve TL of an expression of the threshold Tx with respect to the number of determination times CT may be given. At this time, the threshold Tx is determined in accordance with the numerical value of the number of determination times CT stored in the counting portion 48.

In the preferred embodiment described above, when it is determined that |$\Delta$SOC| is equal to or more than the first threshold T1 or when it is determined that |$\Delta$SOC| is equal to or more than the second threshold T2, the counting portion 48 initializes the number of determination times CT, but the technology disclosed herein is not limited thereto. The counting portion 48 may be configured to store a numerical value obtained by subtracting a predetermined numerical value from the number of determination times CT in the above-described case. Alternatively, the counting portion 48 may be configured to store a numerical value obtained by dividing the numerical number of the number of determination times CT by a predetermined value.

One preferred embodiment described above is merely an example of a battery full charge capacity estimation disclosed herein. The technology disclosed herein can be implemented in various other preferred embodiments. Other preferred embodiments of the technology disclosed herein will be described below.

<Second Preferred Embodiment>

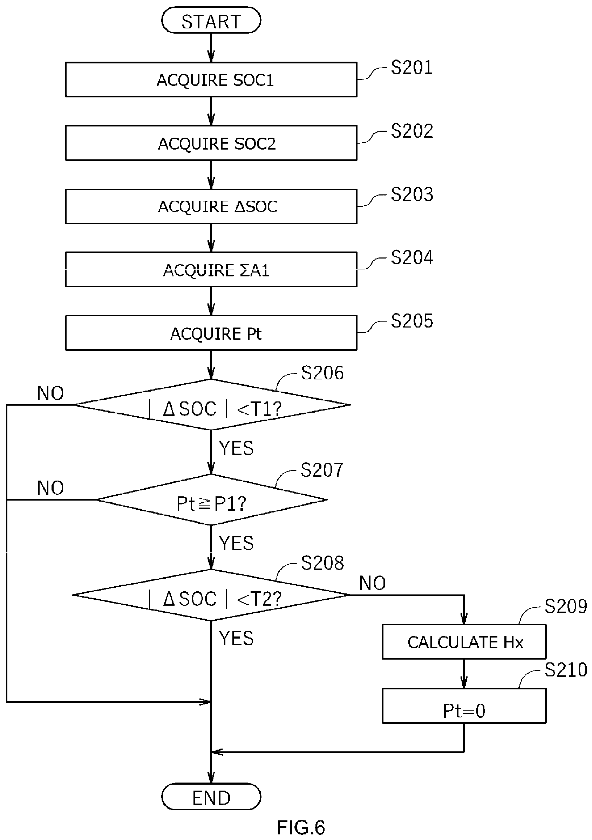

For example, in the first preferred embodiment described above, whether to relax the threshold Tx is determined based on the number of times it has been determined that |$\Delta$SOC| is smaller than the threshold Tx, but the technology disclosed herein is not limited thereto. FIG. 6 is a flowchart for estimating the full charge capacity of the battery 1 according to a second preferred embodiment. Note that, similar to the first preferred embodiment, a flow illustrated in FIG. 6 is performed at the time t3 (see FIG. 2). However, a timing at which the flow starts is not limited thereto.

Steps S201 to S204 illustrated in FIG. 6 are similar to Steps S101 to S104 illustrated in FIG. 3, and therefore, description thereof will be omitted.

Step S205 illustrated in FIG. 6 is a step of acquiring an unexecuted time Pt that has elapsed with no estimated value Hx acquired since the estimated value Hx was previously acquired. Step S205 can be realized by the unexecuted time measurement portion 50 (see FIG. 1) and the unexecuted time acquisition portion 51 (see FIG. 1) of the control device 40. The unexecuted time measurement portion 50 starts measurement of a time from a time when the estimation portion 46 previously calculated the estimated value Hx. That is, when calculation of the estimated value Hx by the estimation portion 46 is executed, the unexecuted time measurement portion 50 initializes the unexecuted time Pt that has been measured and starts measurement again. As used herein, the term "initializing the unexecuted time Pt that has been measured" refers to, for example, making a value of the unexecuted time Pt that has been measured be 0. In Step S205, the unexecuted time acquisition portion 51 of the control device 40 acquires the unexecuted time Pt that has been measured by the unexecuted time measurement portion 50. That is, an elapsed time from a time when the estimated value Hx was previously calculated to a time when the process reaches Step S205 is acquired. Note that an order of execution of Step S205 is not limited to an order illustrated in FIG. 6. Step S205 may be executed before Step S207 is executed.

Step S206 is a step of determining whether the absolute value |ΔSOC| of the change amount ΔSOC is lower than the preset threshold Tx. Step S206 is similar to Step S105 (see FIG. 3) in the first preferred embodiment, and therefore, detailed description thereof will be omitted herein. In Step S206, when it is determined that |ΔSOC| is lower than the first threshold T1, the process proceeds to Step S207. When it is determined that |ΔSOC| is equal to or more than the first threshold, the flow ends.

Step S207 is a step of determining whether the unexecuted time Pt acquired by the unexecuted time acquisition portion 51 is equal to or more than a preset time.

Step S207 can be realized by the time determination portion 52 (see FIG. 1) of the control device 40. In this preferred embodiment, the time determination portion 52 determines whether the unexecuted time Pt is equal to or more than an upper limit time P1. Although there is no particular limitation on a value of the upper limit time P1, for example, the upper limit time P1 is about one week to one month. In Step S207, when it is determined that the unexecuted time Pt is equal to or more than the upper limit time P1, the estimation portion 46 changes the threshold Tx from the first threshold T1 to the second threshold T2. Thereafter, the process proceeds Step S208. When it is determined that the unexecuted time Pt is less than the upper limit time P1, the flow ends.

Step S208 is a step of determining whether |ΔSOC| is lower than the preset threshold Tx. As described above, in Step S207, the threshold Tx is set to the second threshold T2. Therefore, in Step S208, it is determined whether |ΔSOC| is lower than the preset second threshold T2. Determination in Step S208 can be realized by the determination portion 47 (see FIG. 1). In Step S208, when it is determined that |ΔSOC| is lower than the second threshold T2, the flow ends. When it is determined that the value of |ΔSOC| is not lower than the second threshold T2, that is, that the value of |ΔSOC| is equal to or more than the second threshold T2, the process proceeds to Step S209.

Step S209 is a step of acquiring, when it is determined that |ΔSOC| is equal to or more than the preset second threshold T2, the estimated value Hx of the full charge capacity of the battery 1, based on Expression 1. Step S209 can be realized by the estimation portion 46.

Step S210 is a step of initializing the unexecuted time Pt. In Step S210, the unexecuted time measurement portion 50 initializes the unexecuted time Pt that has been measured. Herein, the unexecuted time measurement portion 50 sets the unexecuted time Pt to "0." When Step S210 is executed, the flow ends.

As described above, according to the full charge capacity estimation method for estimating the full charge capacity of the battery 1 according to the second preferred embodiment, when it is determined that the unexecuted time Pt is equal to or more than the upper limit time P1, the threshold Tx is changed from the first threshold T1 to the second threshold T2. Therefore, when the upper limit time P1 has elapsed since the estimated value Hx was previously calculated, the threshold Tx is relaxed regardless of whether |ΔSOC| is lower than the first threshold T1. For example, when the number of times that the ignition is turned on or off is relatively small (when there are relatively few chances to drive an electric vehicle on which the battery system 100 is mounted), there is a probability that the number of times determination by the determination portion 47 is executed is relatively small. Therefore, there is a probability that a deviation between the estimated value Hx previously acquired and the actual full charge capacity of the battery 1 arises. However, according to the full charge capacity estimation method for estimating the full charge capacity of the battery 1 in this preferred embodiment, when the upper limit time P1 has elapsed since the estimated value Hx was previously calculated, the threshold Tx is relaxed. Therefore, estimation of the estimated value Hx is executed relatively often. Thus, it is possible to suppress that a deviation between the estimated value Hx and the actual full charge capacity of the battery 1 arises.

In the second preferred embodiment described above, the threshold Tx is changed using the first threshold T1 and the second threshold T2, but the technology disclosed herein is not limited thereto. The threshold Tx may be changed twice or more. For example, determination by the time determination portion 52 may be performed using the upper limit time P1 and a longer time than the upper limit time P1.

In the second preferred embodiment described above, after whether |ΔSOC| is lower than the first threshold T1 (Step S206) is determined, determination on whether the unexecuted time Pt is equal to or more than the upper limit time P1 is executed (Step S207), but the technology disclosed herein is not limited thereto. Step S207 may be executed before Step S206. In this case, when it is determined that the unexecuted time Pt is equal to or more than the upper limit time P1, the step of determining whether |ΔSOC| is lower than the first threshold T1 may be omitted.

<Third Preferred Embodiment>

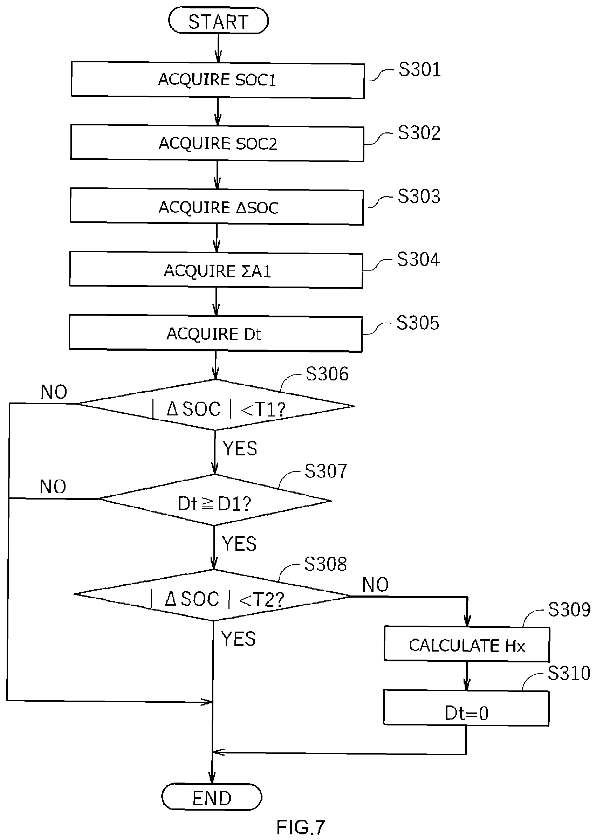

For example, in the first preferred embodiment described above, whether the threshold Tx is relaxed is determined based on the number of times it has been determined that |ΔSOC| is smaller than the threshold Tx, but the technology disclosed herein is not limited thereto. FIG. 7 is a flowchart for estimating a full charge capacity of the battery 1 according to a third preferred embodiment. Note that, similar to the first preferred embodiment, a flow illustrated in FIG. 7 is performed at the time t3 (see FIG. 2). However, a timing at which the flow starts is not limited thereto.

Steps S301 to S304 illustrated in FIG. 7 are similar to Steps S101 to S104 illustrated in FIG. 3, and therefore, description thereof will be omitted.

Step S305 illustrated in FIG. 7 is a step of acquiring a travel distance Dt that is a distance the electric vehicle on which the battery system 100 is mounted has traveled since the estimated value Hx was previously acquired. Step S305 can be realized by the travel distance measuring portion 53 (see FIG. 1) and the travel distance acquisition portion 54 (see FIG. 1) of the control device 40. The travel distance measuring portion 53 of the control device 40 starts measurement of the travel distance Dt from a time when the estimation portion 46 previously calculated the estimated value Hx. That is, when acquisition of the estimated value Hx by the estimation portion 46 is executed, the travel distance measuring portion 53 initializes the travel distance Dt that has been measured and starts measurement again. As used herein, the term "initializing a distance that has been measured" refers to, for example, making a travel distance that has been measured be 0. The travel distance acquisition portion 54 of the control device 40 acquires the travel distance Dt that the travel distance measuring portion 53 measures in Step S305. That is, a travel distance in a period from a time when the estimated value Hx was previously calculated to a time when the process reaches Step S305 is acquired. Note that an order of execution of Step S305 is not limited to an order illustrated in FIG. 7. Step S305 may be executed before Step S307 is executed.

Step S306 is a step of determining whether the absolute value |ΔSOC| of the change amount ΔSOC is lower than the preset threshold Tx. Step S306 is similar to Step S105 (see FIG. 3) in the first preferred embodiment, and therefore, detailed description thereof will be omitted herein. In Step S306, when it is determined that |ΔSOC| is lower than the first threshold T1, the process proceeds to Step S307. When it is determined that |ΔSOC| is equal to or more than the first threshold, the flow ends.

Step S307 is a step of determining whether the travel distance Dt acquired by the travel distance measuring portion 53 is equal to or more than a preset distance. Step S307 can be realized by the distance determination portion 55 (see FIG. 1). In this preferred embodiment, the distance determination portion 55 determines whether the travel distance Dt is equal to or more than an upper limit distance D1. Although there is no particular limitation on a value of the upper limit distance D1, for example, the value of the upper limit distance D1 is about 1000 km to 10000 km. In Step S307, when it is determined that the travel distance Dt is equal to or more than the upper limit distance D1, the estimation portion 46 changes the threshold Tx from the first threshold T1 to the second threshold T2. Thereafter, the process proceeds to Step S308. When it is determined that the travel distance Dt is less than the upper limit distance D1, the flow ends.

Step S308 is a step of determining whether |ΔSOC| is lower than the preset threshold Tx. In Step S308, the threshold Tx is set to the second threshold T2. Step S308 is similar to Step S208 (see FIG. 6) in the second preferred embodiment, and therefore, description thereof will be omitted.

Step S309 is a step of acquiring, when it is determined that |ΔSOC| is equal to or more than the preset second threshold T2, the estimated value Hx of the full charge capacity of the battery 1, based on Expression 1. Step S309 can be realized by the estimation portion 46.

Step S310 is a step of initializing the travel distance Dt. In Step S310, the travel distance measuring portion 53 initializes the travel distance Dt that has been measured. Herein, the travel distance measuring portion 53 sets travel distance Dt to "0." When Step S301 is executed, the flow ends.

As described above, according to the full charge capacity estimation method for estimating the full charge capacity of the battery 1 according to the third preferred embodiment, when it is determined that the travel distance Dt is equal to or more than the upper limit distance D1, the threshold Tx is changed from the first threshold T1 to the second threshold T2. Therefore, when the electric vehicle has traveled a distance that is equal to or more than the upper limit distance D1 since the estimated value Hx was previously calculated, the threshold Tx is relaxed regardless of whether |ΔSOC| is lower than the first threshold T1. For example, when a travel distance per drive (from a time when the ignition is turned on to a time when the ignition is turned off) of the electric vehicle is relatively long, depending on charging and discharging during traveling, there is a probability that the number of times determination by the determination portion 47 is executed is relatively small. As the travel distance increases, the full charge capacity of the battery 1 is deteriorated. Therefore, in this case, there is a probability that a deviation between the estimated value Hx previously calculated and the actual full charge capacity of the battery 1 arises. However, according to the full charge capacity estimation method for estimating the full charge capacity of the battery 1 in this preferred embodiment, when the travel distance Dt is equal to or more than the upper limit distance D1, the threshold Tx is relaxed. Therefore, estimation of the estimated value Hx is executed relatively often. Thus, it is suppressed that the estimated value Hx is not acquired for a relatively long period even when the travel distance is relatively long, and it is possible to suppress that a deviation between the estimated value Hx and the actual full charge capacity of the battery 1 arises.

In the third preferred embodiment described above, the threshold Tx is changed using the first threshold T1 and the second threshold T2, but the technology disclosed herein is not limited thereto. The threshold Tx may be changed twice or more. For example, determination by the distance determination portion 55 may be performed using the upper limit distance D1 and a longer distance than the upper limit distance D1.

In the third preferred embodiment described above, after whether $|\Delta SOC|$ is lower than the first threshold T1 is determined (Step S306), determination on whether the travel distance Dt is equal to or more than the upper limit distance D1 (Step S307) is executed, but the technology disclosed herein is not limited thereto. Step S307 may be executed before Step S306. In this case, when it is determined that the travel distance Dt is equal to or more than the upper limit distance D1, the step of determining whether $|\Delta SOC|$ is lower than the first threshold T1 may be omitted.

<Fourth Preferred Embodiment>

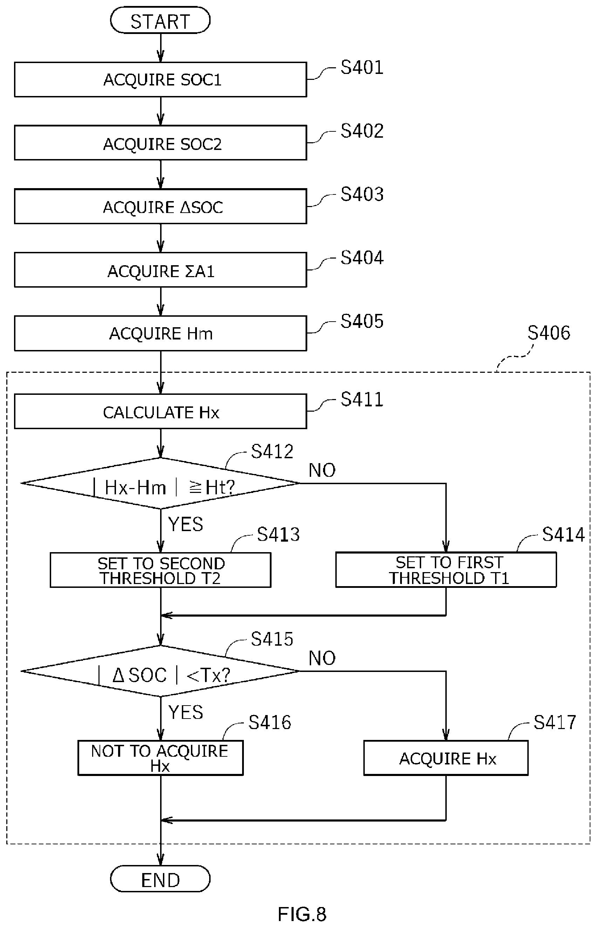

For example, in the third preferred embodiment described above, the threshold Tx is changed from the first threshold T1 to the second threshold T2 based on comparison between the travel distance Dt and the preset travel distance (upper limit distance D1), but the technology disclosed herein is not limited thereto. FIG. 8 is a flowchart for estimating the full charge capacity of the battery 1 according to a fourth preferred embodiment. Similar to the first preferred embodiment, a flow illustrated in FIG. 8 is performed at the time t3 (see FIG. 2). However, a timing at which the flow starts is not limited thereto.

Steps S401 to S404 illustrated in FIG. 8 are similar to Steps S101 to S104 illustrated in FIG. 3, and therefore, description thereof will be omitted.

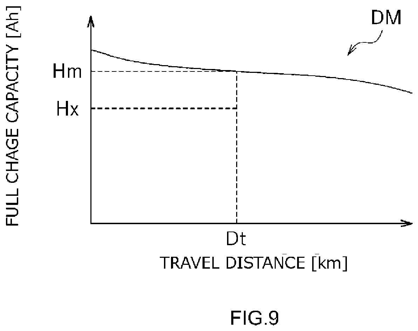

Step S405 illustrated in FIG. 8 is a step of acquiring a full charge capacity Hm in a capacity deterioration model recorded in advance for preset information of the battery 1 and the full charge capacity of the battery 1 (which will be hereinafter simply referred to as a full charge capacity Hm"). A capacity deterioration model DM (see FIG. 9) in this preferred embodiment is a model representing a relationship between the travel distance Dt that the electric vehicle on which the battery system 100 is mounted has traveled and the full charge capacity of the battery 1. The travel distance Dt is the same as the travel distance Dt in the third preferred embodiment.

FIG. 9 is a graph representing the capacity deterioration model DM of the battery 1. The capacity deterioration model DM is a graph representing a relationship between the travel distance of the electric vehicle on which the battery system 100 is mounted and the full charge capacity of the battery 1. An ordinate of the capacity deterioration model DM represents the full charge capacity. An abscissa of the capacity deterioration model DM represents the travel distance of the electric vehicle. The capacity deterioration model DM is acquired in advance by test, simulation, theoretical calculation, or the like, and is stored in the control device 40. In Step S405, similar to the third preferred embodiment, the travel distance acquisition portion 54 (see FIG. 1) acquires the travel distance Dt. The estimated capacity acquisition portion 56 (see FIG. 1) of the control device 40 acquires the full charge amount Hm at the travel distance Dt from the capacity deterioration model DM.

Step S406 illustrated in FIG. 8 is a step of acquiring the estimated value Hx of the full charge capacity of the battery 1. Note that Step S406 includes Steps S411 to S417.

Step S411 is a step of calculating the estimated value Hx, based on Expression 1, by the estimation portion 46. Step S412 is a step of determining whether each of the estimated value Hx and the travel distance Dt has a difference that is equal to or more than a preset value with respect to the capacity deterioration model DM recorded in advance for the preset information and the full charge capacity. Step S412 can be realized by the estimated value determination portion 57 (see FIG. 1) of the control device 40. In this preferred embodiment, the estimated value determination portion 57 determines whether each of the estimated value Hx estimated by the estimation portion 46 and the travel distance Dt has a difference that is equal to or more than the preset value with respect to the capacity deterioration model DM. In this preferred embodiment, the estimated value determination portion 57 determines whether an absolute value $|Hx - Hm|$ of a difference between the estimated value Hx and the full charge capacity Hm of the capacity deterioration model DM is equal to or more than a preset threshold Ht. There is no particular limitation on a value of the threshold Ht. In Step S412, when it is determined that $|Hx - Hm|$ is equal to or more than the preset threshold Ht, the process proceeds to Step S413. In Step S412, when it is determined that $|Hx - Hm|$ is smaller than Ht, the process proceeds to Step S414.

Step S413 is a step of making the first threshold T1 be the second threshold T2 in the step of acquiring the estimated value Hx of the full charge capacity. Since it has been determined in Step S412 that $|Hx - Hm|$ is equal to or more than Ht, in Step S413, the estimation portion 46 sets the threshold Tx from the first threshold T1 to the second threshold T2 regardless of the number of determination times CT stored in the counting portion 48 (see FIG. 1). Step S414 is a step of setting the threshold Tx to the first threshold T1. Since it has been determined in Step S412 that $|Hx - Hm|$ is smaller than Ht, in Step S414, the estimation portion 46 maintains the threshold Tx at the first threshold T1. When Step S413 or Step S414 is executed, the process proceeds to Step S415.

Step S415 is a step of determining whether $|\Delta SOC|$ is lower than the preset threshold Tx. Note that, in Step S413, when the threshold Tx is set to the second threshold T2, in Step S415, determination is executed using the second threshold T2. In Step S414, when the threshold Tx is set to the first threshold T1, in Step S415, determination is executed using the first threshold T1. Step S415 is executed by the determination portion 47 (see FIG. 1). In Step S415, when it is determined that |ΔSOC| is lower than the threshold Tx, the process proceeds to Step S416. When it is determined that |ΔSOC| is equal to or more than the Threshold Tx, the process proceeds to Step S417.

Step S416 is a step of not using the estimated value Hx as an estimated value of the full charge capacity of the battery 1. Since it has been determined in Step S415 that |ΔSOC| is lower than the threshold Tx, the control device 40 does not use the estimated value Hx calculated by the estimation portion 46 in Step S411 as the estimated value of the full charge capacity of the battery 1. At this time, the calculated estimated value Hx is deleted. Step S417 is a step of using the estimated value Hx as the estimated value of the full charge capacity of the battery 1. Since it has been determined in Step S415 that |ΔSOC| is equal to or more than the threshold Tx, the control device 40 uses the estimated value Hx calculated by the estimation portion 46 in Step S411 as the estimated value of the full charge capacity of the battery 1.

As described above, according to the full charge capacity estimation method for estimating the full charge capacity of the battery 1 according to the fourth preferred embodiment, when it is determined by the estimated value determination portion 57 that |Hx - Hm| is equal to or more than Ht, the threshold Tx is changed from the first threshold T1 to the second threshold T2. Therefore, when there is a difference that is equal to or more than a preset value with respect to the capacity deterioration model DM, a condition under which the estimated value Hx is calculated is relaxed regardless of whether |ΔSOC| is lower than the first threshold T1. Depending on a use state of the electric vehicle, the full charge capacity of the battery 1 is relatively largely deviated with respect to the capacity deterioration model DM in some cases. By relaxing a condition under which the estimated value Hx is acquired, the number of times the estimated value Hx is calculated and is acquired is increased. Thus, the value that is acquired for the estimated value Hx can be made to gradually approximate the capacity deterioration model DM.

In the fourth preferred embodiment described above, in Step S412, it is determined whether the absolute value |Hx - Hm| of the difference between the estimated value Hx and the full charge capacity Hm is larger than the preset threshold Ht, but the technology disclosed herein is not limited thereto. Whether there is a different that is equal to or more than a preset value with respect to the capacity deterioration model DM may be determined based on the travel distance. That is, it may be determined, in the capacity deterioration model DM, whether each of the travel distance corresponding to the estimated value Hx and the travel distance Dt has a difference that is equal to or more than a preset value.

In the fourth preferred embodiment described above, the capacity deterioration model DM is a model representing the relationship between the travel distance Dt and the full charge capacity of the battery 1, but the technology disclosed herein is not limited thereto. For example, the capacity deterioration model may be a model recorded for a temperature of the battery 1 at use, information of SOC, ΔSOC, or the like, the full charge capacity of the battery 1 in advance.

In each of the preferred embodiments described above, the threshold Tx is a threshold for the ΔSOC, but the technology disclosed herein is not limited thereto. For example, the threshold Tx may be a threshold for the current integrated value ΣA1. In this case, the determination portion 47 determines whether the current integrated value ΣA1 is lower than a preset threshold. Alternatively, the threshold Tx may be a threshold that is used for determining whether a time during which the current integrated value ΣA1 is acquired, that is, a time from a time when the ignition is turned on to a time when the ignition is turned off, is lower than a preset threshold.

A full charge capacity estimation program 40a of this preferred embodiment may be stored, for example, in a non-transitory computer readable medium. The program can be supplied to a computer via the non-transitory computer readable medium. Note that examples of the non-transitory computer readable medium include a magnetic recording medium (for example, a flexible disk, a magnetic tape, or a hard disk drive), a read only memory (CD-ROM), or the like.

The invention disclosed herein has been described above in various forms. However, the preferred embodiments described above or the like shall not limit the present invention, unless specifically stated otherwise. Various changes can be made to the preferred embodiments of the invention disclosed herein, and each of components and processes described herein can be omitted as appropriate or can be combined with another one or other ones of the components and the processes as appropriate, unless a particular problem occurs. For example, setting the threshold Tx may be performed using determination of the number of determination times CT by the frequency determination portion 49 and determination of the unexecuted time Pt by the time determination portion 52. Setting the threshold Tx may be performed such that, when either one of a condition for determination of the frequency determination portion 49 and a condition for determination of the time determination portion 52 is satisfied, the first threshold T1 is changed to the second threshold T2 by the estimation portion 46, or like setting may be performed.

As described above, the present specification includes disclosure set force in the following items.

First Item: A battery full charge capacity estimation method for estimating a capacity deterioration of a battery managed by a battery management system (BMS) mounted on an electric vehicle, the battery full charge capacity estimation method including steps of acquiring SOC1 that is SOC obtained based on a voltage V1 that is OCV of the battery, acquiring SOC2 that is SOC obtained based on a voltage V2 that is OCV of the battery at a time after the SOC of the battery is SOC1, acquiring a change amount ΔSOC between the SOC1 and the SOC2, acquiring a current integrated value ΣA1 of the battery until the SOC changes from the SOC1 to the SOC2, and acquiring, when |ΔSOC| is equal to or more than a preset first threshold, an estimated value Hx of a full charge capacity of the battery, based on Expression 1 as follows:

$$\text{Expression 1: } Hx = (\Sigma A1/\Delta SOC) \times 100,$$

in which in the step of acquiring the estimated value Hx of the full charge capacity, when a preset condition is satisfied, the first threshold is made to be a second threshold that is a lower threshold than the first threshold.

Second Item: The battery full charge capacity estimation method according to the first item, in which the preset condition is that a state where the |ΔSOC| is lower than the first threshold appears consecutively a preset number of times.

Third Item: The battery full charge capacity estimation method according to the first or second item, further including a step of acquiring an unexecuted time that is a time that has elapsed with no estimated value Hx acquired since the estimated value Hx was previously acquired, in which the preset condition is that the unexecuted time is equal to or more than a preset time.

Fourth Item: The battery full charge capacity estimation method according to any one of the first to third items, further including a step of acquiring a travel distance that is a distance the electric vehicle has traveled since the estimated value Hx was previously acquired, in which the preset condition is that the travel distance is equal to or more than a preset distance.

Fifth Item: The battery full charge capacity estimation method according to any one of the first to fourth items, in which the preset condition is that, with respect to a capacity deterioration model recorded for preset information of the battery and the full charge capacity of the battery in advance, the preset information or the estimated value Hx has a difference that is equal to or more than a preset value.

Sixth Item: A battery full charge capacity estimation device that estimates a capacity deterioration of a battery that is managed by a battery management system (BMS) mounted on an electric vehicle, the battery full charge capacity estimation device including a sensor, and a control device, in which the sensor includes a voltage sensor, and a current sensor, the control device includes a first charged state acquisition portion that acquires SOC1 that is SOC obtained based on a voltage V1 that is OCV of the battery detected by the sensor, a second charged state acquisition portion that acquires SOC2 that is SOC obtained based on a voltage V2 that is OCV of the battery detected by the sensor at a time after the SOC of the battery is the SOC1, a change amount acquisition portion that acquires a change amount ΔSOC between the SOC1 and the SOC2, a current integrated value acquisition portion that acquires a current integrated value ΣA1 of the battery until the SOC changes from the SOC1 to the SOC2, and an estimation portion that acquires, when |ΔSOC| is equal to or more than a preset first threshold, an estimated value Hx of a full charge capacity of the battery, based on Expression 1 as follows:

$$\text{Expression 1: } Hx = (\Sigma A1/\Delta SOC) \times 100,$$

in which when a preset condition is satisfied, the estimation portion makes the first threshold be a second threshold that is a lower threshold than the first threshold.

Seventh Item: The battery full charge capacity estimation device according to the sixth item, in which the preset condition is that a state where the |ΔSOC| is lower than the first threshold appears consecutively a preset number of times.

Eighth Item: The battery full charge capacity estimation device according to the sixth or seventh item, in which the control device includes an unexecuted time acquisition portion that acquires an unexecuted time that is a time that has elapsed with no estimated value Hx acquired since the estimated value Hx was previously acquired, and the preset condition is that the unexecuted time is equal to or more than a preset time.

Ninth Item: The battery full charge capacity estimation device according to any one of the sixth to eighth items, in which the control device includes a travel distance acquisition portion that measures a travel distance that is a distance the electric vehicle has traveled since the estimated value Hx was previously acquired, and the preset condition is that the travel distance is equal to or more than a preset distance.

Tenth Item: The battery full charge capacity estimation device according to any one of the sixth to ninth items, in which the preset condition is that, with respect to a capacity deterioration model recorded for preset information of the battery and the full charge capacity of the battery in advance, the preset information or the estimated value Hx has a difference that is equal to or more than a preset value.

Eleventh Item: A battery full charge capacity estimation program for estimating a capacity deterioration of a battery that is managed by a battery management system (BMS) mounted on an electric vehicle, the battery full charge capacity estimation program being configured to cause a computer to realize a first charged state acquisition portion that acquires SOC1 that is SOC obtained based on a voltage V1 that is OCV of the battery, a second charged state acquisition portion that acquires SOC2 that is SOC obtained based on a voltage V2 that is OCV of the battery at a time after the SOC of the battery is the SOC1, a change amount acquisition portion that acquires a change amount ΔSOC between the SOC1 and the SOC2, a current integrated value acquisition portion that acquires a current integrated value ΣA1 of the battery until the SOC changes from the SOC1 to the SOC2, and an estimation portion that acquires, when |ΔSOC| is equal to or more than a preset first threshold, an estimated value Hx of a full charge capacity of the battery, based on Expression 1 as follows:

$$\text{Expression 1: } Hx = (\Sigma A1/\Delta SOC) \times 100,$$

in which when a preset condition is satisfied, the estimation portion makes the first threshold be a second threshold that is a lower threshold than the first threshold.

Twelfth Item: The battery full charge capacity estimation program according to the eleventh item, in which the preset condition is that a state where the |ΔSOC| is lower than the first threshold appears consecutively a preset number of times.

Thirteenth Item: The battery full charge capacity estimation program according to the eleventh or twelfth item, the battery full charge capacity estimation program being configured to further cause the computer to realize an unexecuted time measuring portion that acquires an unexecuted time that is a time that has elapsed with no estimated value Hx acquired since the estimated value Hx was previously acquired, in which the preset condition is that the unexecuted time is equal to or more than a preset time.

Fourteenth Item: The battery full charge capacity estimation program according to any one of the eleventh to thirteenth items, the battery full charge capacity estimation program being configured to further cause the computer to realize a travel distance acquisition portion that acquires a travel distance that is a distance the electric vehicle has traveled since the estimated value Hx was previously acquired, in which the preset condition is that the travel distance is equal to or more than a preset distance.

Fifteenth Item: The battery full charge capacity estimation program according to any one of the eleventh to fourteenth items, in which the preset condition is that, with respect to a capacity deterioration model recorded for preset information of the battery and the full charge capacity of the battery in advance, the preset information or the estimated value Hx has a difference that is equal to or more than a preset value.

## Claims

1. A battery full charge capacity estimation method for estimating a capacity deterioration of a battery (1) managed by a battery management system (BMS) mounted on an electric vehicle, the battery full charge capacity estimation method comprising steps of:

   acquiring SOC1 that is SOC obtained based on a voltage V1 that is OCV of the battery (1) (S101);
   acquiring SOC2 that is SOC obtained based on a voltage V2 that is OCV of the battery (1) at a time after the SOC of the battery is SOC1 (S102);
   acquiring a change amount ΔSOC between the SOC1 and the SOC2 (S103);
   acquiring a current integrated value ΣA1 of the battery until the SOC changes from the SOC1 to the SOC2 (S104); and
   acquiring, when |ΔSOC| is equal to or more than a preset first threshold, an estimated value Hx of a full charge capacity of the battery, based on Expression 1 as follows (S111):

$$\text{Expression 1: } Hx = (\Sigma A1/\Delta SOC) \times 100,$$

   wherein
   in the step of acquiring the estimated value Hx of the full charge capacity, when a preset condition is satisfied, the first threshold (T1) is made to be a second threshold (T1) that is a lower threshold than the first threshold (T1).

2. The battery full charge capacity estimation method according to claim 1,
   wherein
   the preset condition is that a state where the |ΔSOC| is lower than the first threshold appears consecutively a preset number of times (N1).

3. The battery full charge capacity estimation method according to claim 1 or 2, further comprising:

   a step of acquiring an unexecuted time (Pt) (S205) that is a time that has elapsed with no estimated value Hx acquired since the estimated value Hx was previously acquired,
wherein
the preset condition is that the unexecuted time (Pt) is equal to or more than a preset time (P1).

4.  The battery full charge capacity estimation method according to claims 1 to 3, further comprising:

    a step of acquiring a travel distance (Dt) (S305) that is a distance the electric vehicle has traveled since the estimated value Hx was previously acquired,
    wherein
    the preset condition is that the travel distance (Dt) is equal to or more than a preset distance (D1).

5.  The battery full charge capacity estimation method according to claims 1 to 4,
    wherein
    he preset condition is that, with respect to a capacity deterioration model (DM) recorded for preset information (Dt) of the battery (1) and the full charge capacity of the battery (1) in advance, the preset information (Dt) or the estimated value Hx has a difference that is equal to or more than a preset value (Ht).

6.  A battery full charge capacity estimation device (20) that estimates a capacity deterioration of a battery (1) that is managed by a battery management system (BMS) mounted on an electric vehicle, the battery full charge capacity estimation device (100) comprising:

    a sensor (30); and
    a control device (40),
    wherein
    the sensor (30) includes

        a voltage sensor (31), and
        a current sensor (32),

    the control device (40) includes

        a first charged state acquisition portion (42) that acquires SOC1 that is SOC obtained based on a voltage V1 that is OCV of the battery (1) detected by the sensor (30),
        a second charged state acquisition portion (43) that acquires SOC2 that is SOC obtained based on a voltage V2 that is OCV of the battery (1) detected by the sensor (30) at a time after the SOC of the battery (1) is the SOC1,
        a change amount acquisition portion (44) that acquires a change amount $\Delta$SOC between the SOC1 and the SOC2,
        a current integrated value acquisition portion (45) that acquires a current integrated value $\Sigma$A1 of the battery (1) until the SOC changes from the SOC1 to the SOC2, and
        an estimation portion (46) that acquires, when $|\Delta$SOC$|$ is equal to or more than a preset first threshold (T1), an estimated value Hx of a full charge capacity of the battery (1), based on Expression 1 as follows:

$$\text{Expression 1: Hx} = (\Sigma\text{A1}/\Delta\text{SOC}) \times 100, \text{ and}$$

    when a preset condition is satisfied, the estimation portion (46) makes the first threshold be a second threshold (T2) that is a lower threshold than the first threshold (T1).

7.  The battery full charge capacity estimation device (20) according to claim 6,
    wherein
    the preset condition is that a state where the $|\Delta$SOC$|$ is lower than the first threshold (T1) appears consecutively a preset number of times (N1).

8.  The battery full charge capacity estimation device (20) according to claim 6 or 7,
    wherein

        he control device (40) includes an unexecuted time acquisition portion (51) that acquires an unexecuted time (Pt) that is a time that has elapsed with no estimated value Hx acquired since the estimated value Hx was previously acquired, and

the preset condition is that the unexecuted time (Pt) is equal to or more than a preset time (P1).

**9.** The battery full charge capacity estimation device (20) according to claims 6 to 8,
wherein

the control device (40) includes a travel distance acquisition portion (54) that measures a travel distance (Dt) that is a distance the electric vehicle has traveled since the estimated value Hx was previously acquired, and

the preset condition is that the travel distance (Dt) is equal to or more than a preset distance (D1).

**10.** The battery full charge capacity estimation device (20) according to claims 6 to 9,
wherein
the preset condition is that, with respect to a capacity deterioration model (DM) recorded for preset information (Dt) of the battery (1) and the full charge capacity of the battery (1) in advance, the preset information (Dt) or the estimated value Hx has a difference that is equal to or more than a preset value (Ht).

**11.** A battery full charge capacity estimation program (40a) for estimating a capacity deterioration of a battery (1) that is managed by a battery management system (BMS) mounted on an electric vehicle, the battery full charge capacity estimation program (40a) being configured to cause a computer to realize:

a first charged state acquisition portion (42) that acquires SOC1 that is SOC obtained based on a voltage V1 that is OCV of the battery (1);

a second charged state acquisition portion (43) that acquires SOC2 that is SOC obtained based on a voltage V2 that is OCV of the battery at a time after the SOC of the battery (1) is the SOC1;

a change amount acquisition portion (44) that acquires a change amount $\Delta$SOC between the SOC1 and the SOC2;

a current integrated value acquisition (45) portion that acquires a current integrated value $\Sigma$A1 of the battery (1) until the SOC changes from the SOC1 to the SOC2; and

an estimation portion that acquires, when $|\Delta SOC|$ is equal to or more than a preset first threshold, an estimated value Hx of a full charge capacity of the battery, based on Expression 1 as follows:

$$\text{Expression 1: } Hx = (\Sigma A1/\Delta SOC) \times 100,$$

wherein

when a preset condition is satisfied, the estimation portion (46) makes the first threshold be a second threshold (T2) that is a lower threshold than the first threshold (T1).

**12.** The battery full charge capacity estimation program (40a) according to claim 11,
wherein
the preset condition is that a state where the $|\Delta SOC|$ is lower than the first threshold (T1) appears consecutively a preset number of times (N1).

**13.** The battery full charge capacity estimation program (40a) according to claim 11 or 12, the battery full charge capacity estimation program being configured to further cause the computer to realize:

an unexecuted time measuring portion (50) that acquires an unexecuted time (Pt) that is a time that has elapsed with no estimated value Hx acquired since the estimated value Hx was previously acquired,
wherein
the preset condition is that the unexecuted time (Pt) is equal to or more than a preset time (P1).

**14.** The battery full charge capacity estimation program (40a) according to claims 11 to 13, the battery full charge capacity estimation program being configured to further cause the computer to realize:

a travel distance acquisition portion (54) that acquires a travel distance (Dt) that is a distance the electric vehicle has traveled since the estimated value Hx was previously acquired,
wherein

the preset condition is that the travel distance (Dt) is equal to or more than a preset distance (D1).

15. The battery full charge capacity estimation program (40a) according to claim 11 to 14, wherein
the preset condition is that, with respect to a capacity deterioration model (DM) recorded for preset information (Dt) of the battery (1) and the full charge capacity of the battery (1) in advance, the preset information (Dt) or the estimated value Hx has a difference that is equal to or more than a preset value (Ht).

FIG.1

FIG.2

START

ACQUIRE SOC1 — S101

ACQUIRE SOC2 — S102

ACQUIRE ΔSOC — S103

ACQUIRE ΣA1 — S104

S105
$|\Delta SOC| < T1?$ — NO

YES

S106
$CT \geqq N1?$ — NO

YES

S107
$|\Delta SOC| < T2?$ — NO

YES

S108
$CT \geqq N2?$ — NO

YES

S109
$|\Delta SOC| < T3?$ — NO

YES

CALCULATE Hx — S111

CT=CT+1 — S110

CT=0 — S112

END

FIG.3

FIG.4

FIG.5

START

ACQUIRE SOC1 — S201

ACQUIRE SOC2 — S202

ACQUIRE ΔSOC — S203

ACQUIRE ΣA1 — S204

ACQUIRE Pt — S205

S206

NO ← $|\Delta SOC| < T1$?

YES

S207

NO ← $Pt \geqq P1$?

YES

S208

$|\Delta SOC| < T2$? → NO

YES

CALCULATE Hx — S209

Pt=0 — S210

END

FIG.6

FIG.7

START

ACQUIRE SOC1 — S401

ACQUIRE SOC2 — S402

ACQUIRE ΔSOC — S403

ACQUIRE ΣA1 — S404

ACQUIRE Hm — S405

S406

CALCULATE Hx — S411

S412

| Hx-Hm | ≧ Ht?

NO → SET TO FIRST THRESHOLD T1 — S414

YES → SET TO SECOND THRESHOLD T2 — S413

S415

| ΔSOC | < Tx?

NO → ACQUIRE Hx — S417

YES → NOT TO ACQUIRE Hx — S416

END

FIG.8

FIG.9

Europäisches
Patentamt

European
Patent Office

Office européen
des brevets

**EUROPEAN SEARCH REPORT**

**Application Number**

EP 25 17 0928

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/322283 A1 (ZHANG XIAODONG [US] ET AL) 31 December 2009 (2009-12-31) | 1,6,11 | INV. G01R31/367 |
| Y | * abstract * * paragraph [0011] - paragraph [0023]; figures 1-2 * | 2-5, 7-10, 12-15 | G01R31/3828 G01R31/3842 G01R31/388 G01R31/392 |
| Y | US 2016/049821 A1 (ARIDOME KOJI [JP]) 18 February 2016 (2016-02-18) * abstract * * paragraph [0028] - paragraph [0121]; figures 1-8 * | 2-4,7-9, 12-14 | |
| Y | US 2011/161025 A1 (TOMURA SHUJI [JP] ET AL) 30 June 2011 (2011-06-30) * abstract * * paragraph [0186] - paragraph [0228]; figures 12-25 * | 5,10,15 | |
| A | US 2015/293183 A1 (TENMYO HIROSHI [JP] ET AL) 15 October 2015 (2015-10-15) * abstract * * paragraph [0014] - paragraph [0058]; figures 1-5 * | 1-15 | |
| A | US 2015/134282 A1 (SOGA TSUTOMU [JP] ET AL) 14 May 2015 (2015-05-14) * abstract * * paragraph [0022] - paragraph [0089]; figures 1-12 * | 1-15 | |
| A,D | JP 2002 243813 A (NISSAN MOTOR) 28 August 2002 (2002-08-28) * the whole document * | 1-15 | |
| A | JP 2012 108046 A (HONDA MOTOR CO LTD) 7 June 2012 (2012-06-07) * the whole document * | 1-15 | |

-----

-----

-----

-----

-----

-----

-----

-/--

**TECHNICAL FIELDS SEARCHED (IPC)**

G01R

The present search report has been drawn up for all claims

| Place of search | Date of completion of the search | Examiner |
|---|---|---|
| Munich | 25 September 2025 | Bergado Colina, J |

EPO FORM 1503 03.82 (P04C01)

page 1 of 2

**EP 4 650 799 A1**

Europäisches Patentamt
European Patent Office
Office européen des brevets

# EUROPEAN SEARCH REPORT

**Application Number**

EP 25 17 0928

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2018/335479 A1 (HASHIMOTO HIROAKI [JP]) 22 November 2018 (2018-11-22) * abstract * * paragraph [0021] - paragraph [0081]; figures 1-13 * | 1-15 | |
| A | US 2013/311119 A1 (TAMEZANE SHIGETO [JP]) 21 November 2013 (2013-11-21) * abstract * * paragraph [0050] - paragraph [0148]; figures 1-10 * | 1-15 | |
| A | US 2013/124029 A1 (IZUMI JUNTA [JP]) 16 May 2013 (2013-05-16) * abstract * * paragraph [0029] - paragraph [0097]; figures 1-6 * | 1-15 | |
| A | JP 2014 174050 A (KAYABA INDUSTRY CO LTD) 22 September 2014 (2014-09-22) * the whole document * | 1-15 | **TECHNICAL FIELDS SEARCHED (IPC)** |
| A | JP 2012 185124 A (MITSUBISHI HEAVY IND LTD) 27 September 2012 (2012-09-27) * the whole document * | 1-15 | |
| A | US 2024/066993 A1 (KIM YOUNG-MIN [KR] ET AL) 29 February 2024 (2024-02-29) * abstract * * paragraph [0067] - paragraph [0072]; figures 1-6 * | 1-15 | |
| A | JP 2016 024149 A (TOYOTA MOTOR CORP) 8 February 2016 (2016-02-08) * the whole document * | 1-15 | |

The present search report has been drawn up for all claims

| Place of search | Date of completion of the search | Examiner |
|---|---|---|
| Munich | 25 September 2025 | Bergado Colina, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 2 of 2

25

## ANNEX TO THE EUROPEAN SEARCH REPORT
## ON EUROPEAN PATENT APPLICATION NO.

EP 25 17 0928

This annex lists the patent family members relating to the patent documents cited in the above-mentioned European search report.
The members are as contained in the European Patent Office EDP file on
The European Patent Office is in no way liable for these particulars which are merely given for the purpose of information.

25-09-2025

| Patent document cited in search report | | | Publication date | Patent family member(s) | | Publication date |
|---|---|---|---|---|---|---|
| US 2009322283 | A1 | | 31-12-2009 | CN | 102077105 A | 25-05-2011 |
| | | | | DE | 112009001553 T5 | 29-09-2011 |
| | | | | US | 2009322283 A1 | 31-12-2009 |
| | | | | WO | 2009158226 A2 | 30-12-2009 |
| US 2016049821 | A1 | | 18-02-2016 | CN | 105050855 A | 11-11-2015 |
| | | | | EP | 2976233 A2 | 27-01-2016 |
| | | | | JP | 5812032 B2 | 11-11-2015 |
| | | | | JP | 2014185896 A | 02-10-2014 |
| | | | | US | 2016049821 A1 | 18-02-2016 |
| | | | | WO | 2014147475 A2 | 25-09-2014 |
| US 2011161025 | A1 | | 30-06-2011 | CN | 102144169 A | 03-08-2011 |
| | | | | EP | 2325664 A1 | 25-05-2011 |
| | | | | JP | 4649682 B2 | 16-03-2011 |
| | | | | JP | 2010060384 A | 18-03-2010 |
| | | | | US | 2011161025 A1 | 30-06-2011 |
| | | | | WO | 2010026930 A1 | 11-03-2010 |
| US 2015293183 | A1 | | 15-10-2015 | JP | WO2014083856 A1 | 05-01-2017 |
| | | | | US | 2015293183 A1 | 15-10-2015 |
| | | | | WO | 2014083856 A1 | 05-06-2014 |
| US 2015134282 | A1 | | 14-05-2015 | CN | 104169733 A | 26-11-2014 |
| | | | | EP | 2827164 A1 | 21-01-2015 |
| | | | | JP | 6040724 B2 | 07-12-2016 |
| | | | | JP | 2013217899 A | 24-10-2013 |
| | | | | US | 2015134282 A1 | 14-05-2015 |
| | | | | WO | 2013137141 A1 | 19-09-2013 |
| JP 2002243813 | A | | 28-08-2002 | NONE | | |
| JP 2012108046 | A | | 07-06-2012 | NONE | | |
| US 2018335479 | A1 | | 22-11-2018 | CN | 108369257 A | 03-08-2018 |
| | | | | EP | 3379277 A1 | 26-09-2018 |
| | | | | JP | 6536687 B2 | 03-07-2019 |
| | | | | JP | WO2017085869 A1 | 04-10-2018 |
| | | | | RU | 2690724 C1 | 05-06-2019 |
| | | | | US | 2018335479 A1 | 22-11-2018 |
| | | | | WO | 2017085869 A1 | 26-05-2017 |
| US 2013311119 | A1 | | 21-11-2013 | JP | 5960063 B2 | 02-08-2016 |
| | | | | JP | WO2012105492 A1 | 03-07-2014 |
| | | | | US | 2013311119 A1 | 21-11-2013 |
| | | | | WO | 2012105492 A1 | 09-08-2012 |

EPO FORM P0459

For more details about this annex : see Official Journal of the European Patent Office, No. 12/82

page 1 of 2

## ANNEX TO THE EUROPEAN SEARCH REPORT
## ON EUROPEAN PATENT APPLICATION NO.

EP 25 17 0928

This annex lists the patent family members relating to the patent documents cited in the above-mentioned European search report.
The members are as contained in the European Patent Office EDP file on
The European Patent Office is in no way liable for these particulars which are merely given for the purpose of information.

25-09-2025

| Patent document cited in search report | Publication date | Patent family member(s) | | Publication date |
|---|---|---|---|---|
| US 2013124029 A1 | 16-05-2013 | CN | 103180747 A | 26-06-2013 |
| | | EP | 2596375 A2 | 29-05-2013 |
| | | JP | 5732766 B2 | 10-06-2015 |
| | | JP | 2012029455 A | 09-02-2012 |
| | | US | 2013124029 A1 | 16-05-2013 |
| | | WO | 2012010955 A2 | 26-01-2012 |
| JP 2014174050 A | 22-09-2014 | NONE | | |
| JP 2012185124 A | 27-09-2012 | JP | 5535968 B2 | 02-07-2014 |
| | | JP | 2012185124 A | 27-09-2012 |
| US 2024066993 A1 | 29-02-2024 | CN | 116583754 A | 11-08-2023 |
| | | EP | 4253972 A1 | 04-10-2023 |
| | | ES | 3036385 T3 | 18-09-2025 |
| | | JP | 7568209 B2 | 16-10-2024 |
| | | JP | 2023548898 A | 21-11-2023 |
| | | KR | 20230036929 A | 15-03-2023 |
| | | US | 2024066993 A1 | 29-02-2024 |
| | | WO | 2023038398 A1 | 16-03-2023 |
| JP 2016024149 A | 08-02-2016 | NONE | | |

EPO FORM P0459

For more details about this annex : see Official Journal of the European Patent Office, No. 12/82

page 2 of 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002243813 A